# EUROPEAN PATENT APPLICATION

(11) **EP 2 573 577 A2**
(43) Date of publication of application: **27.03.2013**
(21) Application number: 12184538.2
(22) Date of filing: 14.09.2012
(51) Int. Cl.: G01R 31/327

(54) **Method, device, and system for monitoring a component**

(30) Priority: 19.09.2011 US 201113236152
(71) Applicant: General Electric Company, Schenectady, NY 12345 (US)
(72) Inventor: Williams, Craig Benjamin, Louisville, KY 40225 (US); Greenwood, Todd Elliott, Louisville, KY 40225 (US)
(74) Representative: Picker, Madeline Margaret

(57) **Abstract**

A system (100) includes a sensor (130) configured to provide a signal related to an operating condition of a component, a memory (136) for storing values representative of the operating condition, and a processor (128) coupled to the sensor and to the memory. The processor is programmed to calculate a first value of the operating condition during a first period of time based on the stored values, calculate a second value of the operating condition during a second period of time using the first value, and determine a status of the component using the second value.

## Description

### BACKGROUND OF THE INVENTION

The present application relates generally to monitoring systems and, more particularly, to a method, device, and system for use in monitoring a component.

Known electric distribution circuits and switchgear generally have conductors that are separated by insulation, such as air, or gas or solid dielectrics. However, if the conductors are positioned too closely together, or if a voltage between the conductors exceeds the insulative properties of the insulation between the conductors, an arc can occur. For example, the insulation between the conductors can become ionized, which makes the insulation conductive and enables formation of an arc flash.

An arc flash includes a rapid release of energy due to a fault between two phase conductors, between a phase conductor and a neutral conductor, or between a phase conductor and a ground point. Arc flash temperatures can reach or exceed 20,000°C, which can vaporize the conductors and adjacent equipment. In addition, an arc flash can release significant energy in the form of heat, intense light, pressure waves, and/or sound waves, sufficient to damage the conductors and adjacent equipment. However, the current level of a fault that generates an arc flash is generally less than the current level of a short circuit, such that a circuit breaker generally does not trip or may exhibit a delayed trip unless the circuit breaker is specifically designed to handle an arc fault condition.

At least some known circuit breakers or other trip devices are included within electronic trip units that programmably interrupt a current provided to a load. The trip devices and the circuit protection devices may be installed in switchgear or other power distribution systems that may provide electricity to important revenue-generating machinery and/or to machines or devices that are highly desirable to maintain in operation. Such trip devices may degrade over time, and may unexpectedly fail due to such degradation. In addition, the reliability of known trip devices may be reduced by operating the trip devices in high temperature and/or high humidity environments. If the trip device fails, the machines and/or devices coupled to the trip device may be damaged and/or may undesirably lose power. Accordingly, it would be desirable to predict or determine when the trip device is about to fail so that preventative action may be taken to replace or fix the trip device.

### BRIEF DESCRIPTION OF THE INVENTION

In one aspect, a system is provided that includes a sensor configured to provide a signal related to an operating condition of a component, a memory for storing values representative of the operating condition, and a processor coupled to the sensor and to the memory. The processor is programmed to calculate a first value of the operating condition during a first period of time based on the stored values, calculate a second value of the operating condition during a second period of time using the first value, and determine a status of the component using the second value.

In another aspect, a circuit protection device for use in electrically protecting a load is provided. The circuit protection device includes a trip mechanism configured to interrupt a current provided to the load and a sensor configured to provide a signal related to an operating condition of said trip mechanism. The circuit protection device also includes a memory for storing values representative of the operating condition and a processor coupled to the trip mechanism, to the sensor, and to the memory. The processor is programmed to calculate a first value of the operating condition during a first period of time based on the stored values, calculate a second value of the operating condition during a second period of time using the first value, and determine a status of the trip mechanism using the second value.

In another aspect, a method for monitoring a component is provided that includes measuring an operating condition of the component and storing values representative of the operating condition in a memory, wherein the operating condition includes a temperature of the component. The method also includes calculating, by a processor, a first value of the operating condition during a first period of time based on the stored values, calculating, by a processor, a second value of the operating condition during a second period of time using the first value, and determining, by a processor, a remaining useful life of the component using the second value.

### BRIEF DESCRIPTION OF THE DRAWINGS

Fig. 1 is a schematic block diagram of an example power system.
Fig. 2 is a schematic block diagram of an example power distribution system that may be used with the power system shown in Fig. 1.
Fig. 3 is a flow diagram of an example method for monitoring a component.

### DETAILED DESCRIPTION OF EMBODIMENTS OF THE INVENTION

Example embodiments of a method, device, and system for use in monitoring a component are described herein. These embodiments facilitate monitoring and/or determining a status, such as a remaining useful life, of the component. An operating condition of the component is measured and values representative of the measured operating condition are stored in a memory. A processor calculates a first average value of the operating condition during an interval time period. The processor receives an average value of the operating condition from a prior time period. The processor calculates a second average value of the operating condition over the operational lifetime of the component using the first average value and the average value during the prior time period. The remaining useful life of the component is determined based on the average value of the operating condition during the operational lifetime of the component, the duration of the operational lifetime of the component, and an expected component lifetime obtained from a reliability model. If the remaining useful life of the component is below a threshold, a warning is issued and/or an action is implemented to increase the remaining useful life of the component. Accordingly, a failure of the component may be predicted or determined with greater accuracy such that the component is less likely to fail unexpectedly.

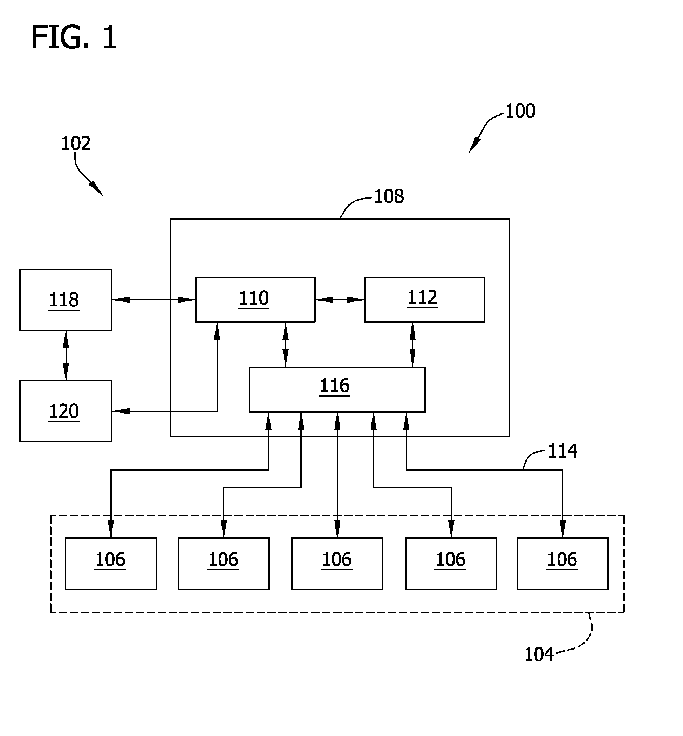

Fig. 1 is a schematic block diagram of an example power system 100 that includes an equipment protection system 102 and a distribution system 104. In an example embodiment, distribution system 104 includes a plurality of switchgear units 106. Protection system 102 includes a central controller 108 that includes a processor 110 and a memory 112 coupled to processor 110. Processor 110 controls and/or monitors operation of switchgear units 106. More specifically, processor 110 controls and/or monitors operation of a plurality of circuit breakers and trip units (neither shown in Fig. 1) within switchgear units 106. Processor 110 communicates with switchgear units 106 through a network 114. For example, central controller 108 includes a central communication unit 116 that enables transmitting and receiving data and/or commands between processor 110 and switchgear units 106 through network 114.

It should be understood that the term "processor" refers generally to any programmable system including systems and microcontrollers, reduced instruction set circuits (RISC), application specific integrated circuits (ASIC), programmable logic circuits, and any other circuit or processor capable of executing the functions described herein. The above represent examples only, and thus are not intended to limit in any way the definition and/or meaning of the term "processor."

Memory 112 stores program code and instructions, executable by processor 110, to control and/or monitor switchgear units 106. Memory 112 may include, but is not limited to only include, non-volatile RAM (NVRAM), magnetic RAM (MRAM), ferroelectric RAM (FeRAM), read only memory (ROM), flash memory and/or Electrically Erasable Programmable Read Only Memory (EEPROM). Any other suitable magnetic, optical and/or semiconductor memory, by itself or in combination with other forms of memory, may be included in memory 112. Memory 112 may also be, or include, a detachable or removable memory, including, but not limited to, a suitable cartridge, disk, CD ROM, DVD or USB memory.

In an example embodiment of Fig. 1, protection system 102 includes a display device 118 and a user input device 120 that provide a user interface for monitoring and controlling distribution system 104 using protection system 102. Display device 118 may include, without limitation, a monitor, a television display, a plasma display, a liquid crystal display (LCD), a display based on light emitting diodes (LED), a display based on a plurality of organic light-emitting diodes (OLEDs), a display based on polymer light-emitting diodes (PLEDs), a display based on a plurality of surface-conduction electron-emitters (SEDs), a display including a projected and/or reflected image or any other suitable electronic device or display mechanism. In one embodiment, display device 118 includes a touch-screen with an associated touch-screen controller. Display device 118 may be of any suitable configuration, such as a square, a rectangle or an elongated rectangle. User input device 120 includes, without limitation, a keyboard, a keypad, a touch-sensitive screen, a mouse, a scroll wheel, a pointing device, an audio input device employing speech-recognition software, and/or any suitable device that enables a user to input data into power distribution system 104.

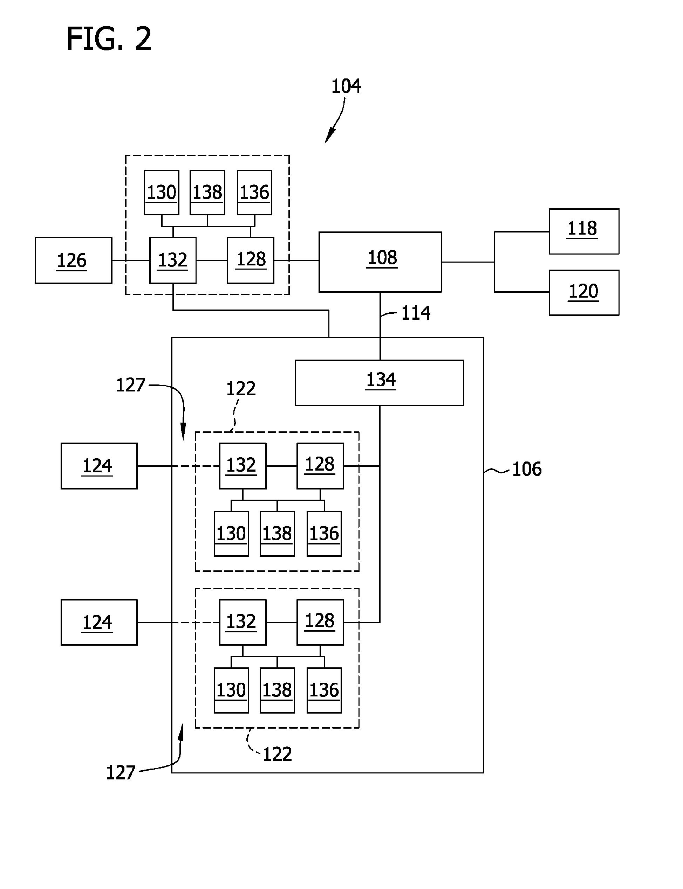

Fig. 2 is a schematic block diagram of power distribution system 104 including a plurality of circuit protection devices 122. Each circuit protection device 122 is removably coupled within switchgear unit 106 and is configured to programmably control power to one or more loads 124. In an example embodiment, circuit protection device 122 is an electronic trip unit (ETU) 122.

Loads 124 may include, but are not limited to only including, machinery, motors, lighting, and/or other electrical and mechanical equipment of a manufacturing or power generation or distribution facility. Power is provided to switchgear unit 106 from a main power feed 126, which is also coupled to circuit protection device 122. The power is then divided into a plurality of branch circuits 127 using circuit protection devices 122 for providing power to loads 124.

Each circuit protection device 122 includes a processor 128, as well as at least one sensor 130 and at least one trip mechanism 132, such as one or more circuit breakers or arc containment devices coupled to processor 128. Example circuit breakers include, for example, circuit switches and/or circuit interrupters that interrupt current flow through the circuit breaker to a load coupled to the circuit breaker. An example arc containment device includes, for example, a containment assembly, a plurality of electrodes, a plasma gun, and a trigger circuit that causes the plasma gun to emit ablative plasma into a gap between the electrodes in order to divert energy into the containment assembly from an arc of other electrical fault that is detected on the circuit.

Sensor 130 measures at least one operating condition of trip mechanism 132 and/or of circuit protection device 122. In an example embodiment, sensor 130 is a temperature sensor 130 that measures a temperature of trip mechanism 132 and/or circuit protection device 122, or of ambient air in close proximity to trip mechanism 132 and/or circuit protection device 122. Alternatively, sensor 130 is a humidity sensor 130 that measures a humidity or moisture content of ambient air surrounding, or in close proximity to, trip mechanism 132 and/or circuit protection device 122 and/or a current sensor, such as a current transformer, a Rogowski coil, a Hall-effect sensor, and/or a shunt that measures a current flowing through trip mechanism 132 and/or circuit protection device 122. Still alternatively, sensor 130 may include a combination of temperature, humidity, and/or current sensors and/or any other type of sensor that enables power distribution system 104 to function as described herein. In an example embodiment, each sensor 130 generates data representative of the measured temperature (hereinafter referred to as "temperature data") and/or data representative of the measured humidity (hereinafter referred to as "humidity data") at, or in close proximity to, an associated trip mechanism 132. In addition, each sensor 130 transmits a signal including, or representing, the temperature data and/or the humidity data to a processor 128 associated with, or coupled to, trip mechanism 132. Each processor 128 is programmed to activate trip mechanism 132 to interrupt a current provided to a load 124 if the temperature data, humidity data, and/or any other operating condition data exceeds a programmable trip threshold.

In an example embodiment, processors 128 are also communicatively coupled to central controller 108. For example, processors 128 may be directly coupled for communication with central controller 108, or may be coupled for communication with central controller 108 through a communication unit 134. Communication between processors 128 and central controller 108 may also be provided through a hardwired communication link or through a wireless communication link. Processors 128 collect measured operating condition data relating to a corresponding trip mechanism 132. For example, each processor 128 gathers measured operating condition data, such as measured temperature and/or humidity data, from a sensor 130 associated with a trip mechanism 132 coupled to processor 128. In some embodiments, processor 128 periodically receives the measured operating condition data at a preselected frequency. For example, processor 128 receives temperature and/or humidity data at a frequency of about every minute, every hour, every day, or any other frequency. Processor 128 stores values representative of the temperature and/or humidity data in a memory 136 coupled to processor 128, and/or transmits the temperature and/or humidity data to central controller 108. In an alternative embodiment, circuit protection devices 122 do not include processors 128, and the functionality of processors 128 is incorporated into central controller 108.

Memory 136 stores program code and instructions, executable by processor 128, to control and/or monitor circuit protection device 122 and/or trip mechanism 132. In an example embodiment, memory 136 includes non-volatile RAM to enable data stored in memory 136 to be retained after a power loss. Alternatively or additionally, memory 136 may include magnetic RAM (MRAM), ferroelectric RAM (FeRAM), read only memory (ROM), flash memory and/or Electrically Erasable Programmable Read Only Memory (EEPROM). Any other suitable magnetic, optical and/or semiconductor memory, by itself or in combination with other forms of memory, may be included in memory 136. Memory 136 may also be, or include, a detachable or removable memory, including, but not limited to, a suitable cartridge, disk, CD ROM, DVD or USB memory.

Circuit protection device 122 also includes a display device 138 coupled to processor 128. In an example embodiment, display device 138 includes one or more light-emitting diodes (LEDs) that indicate a status of circuit protection device 122. For example, processor 128 may activate one or more components (e.g., LEDs) of display device 138 to indicate that current protection device 122 and/or trip mechanism 132 is active and/or operating normally, that a fault or failure has occurred, that a useful life of trip mechanism 132 or another component of circuit protection device 122 is below a threshold, and/or any other status of trip mechanism 132 and/or circuit protection device 122.

While circuit protection device 122 has been described in Fig. 2 with reference to switchgear units 106 of power distribution system 104, it should be recognized that circuit protection device 122, or any components thereof, may be used with any device or system. Additionally or alternatively, sensor 130 and processor 128 may monitor or measure operating conditions, such as temperature and/or humidity, at, or in close proximity to, any other device or system other than trip mechanism 132.

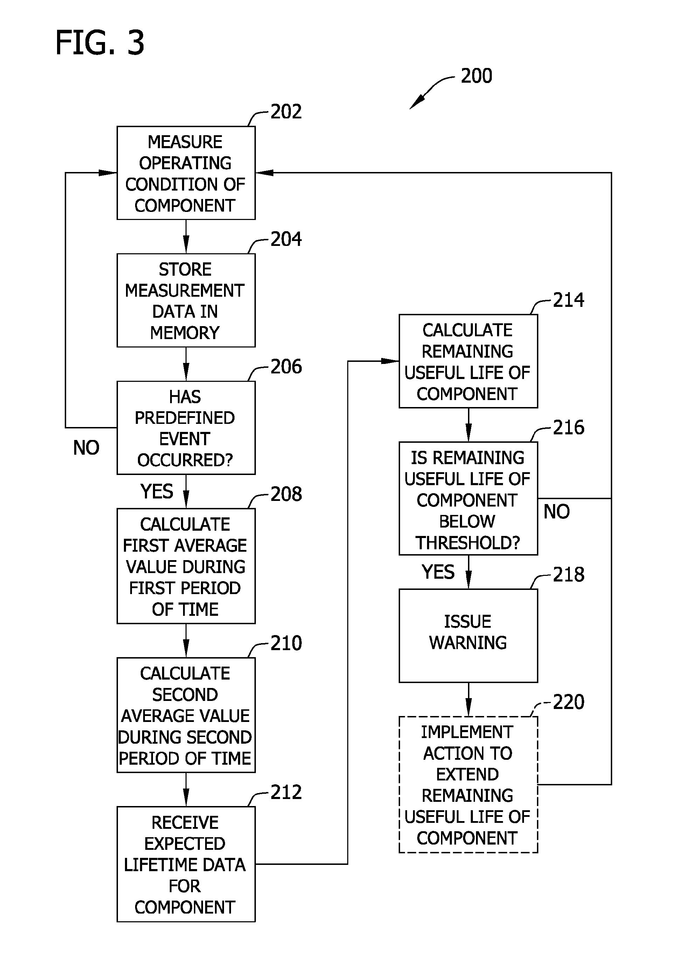

Fig. 3 is a flowchart of an example method 200 for monitoring a component. More specifically, method 200 calculates a status, such as an expected remaining useful life, of a component, such as trip mechanism 132 of circuit protection device 122 (both shown in Fig. 2). Method 200 is at least partially executed by a processor, such as processor 128. For example, a plurality of computer-executable instructions are embodied within a computer-readable medium, such as memory 136 (shown in Fig. 2). The instructions, when executed by the processor, cause the processor to execute the steps of method 200 and/or to function as described herein. Alternatively or additionally, the instructions may be stored within memory 112 and/or may be executed by processor 110 (both shown in Fig. 1) to perform the functions described herein.

In an example embodiment, method 200 includes measuring 202 an operating condition of a component, such as trip mechanism 132 (shown in Fig. 2). For example, sensor 130 measures 202 the temperature of trip mechanism 132 and transmits the temperature data to processor 128. It should be recognized that, while method 200 is described with reference to a measured 202 temperature of trip mechanism 132, method 200 may alternatively or additionally be used to measure a humidity or any other operating condition of trip mechanism 132 and/or any other component of a device or system, such as power distribution system 104. In an example embodiment, sensor 130 measures 202 the operating condition periodically, such as about every minute, about every hour, or at any other frequency. Alternatively, sensor 130 measures 202 the operating condition upon the occurrence of an event, such as a temperature change of the component (or of ambient air in close proximity to the component), a change in the amount of current supplied to load 124 (shown in Fig. 2), a loss of power detected by circuit protection device 122, an input from a user or a device, and/or any other event that enables method 200 to function as described herein.

Processor 128 receives the measurement data (e.g., temperature data) from sensor 130 and stores 204 the measurement data in memory 136. Processor 128 also timestamps the measurement data or otherwise stores a time that each measurement was taken and/or received in memory 136. Processor 128 then determines 206 if a predefined event has occurred. In an example embodiment, the predefined event includes a predefined interval time period elapsing, receiving a signal from user input device 120 (shown in Fig. 1), a startup of a machine or component within power distribution system 104, and/or any other event that enables method 200 to function as described herein.

If the predefined event does not occur, sensor 130 continues to measure 202 the operating condition of the component. However, if the predefined event occurs, processor 128 calculates 208 a first value of the operating condition during a first, or an interval, period of time. In an example embodiment, the first value is an average (or mean) value of the operating condition calculated during the interval time. Alternatively, the first value may be a rolling average, a mode, a median, a range, a standard deviation, or any other value of the operating condition calculated during the interval period of time. In an example embodiment, processor 128 identifies the last time that the average value of the operating condition has been calculated and sets the identified time as an interval start time. Processor 128 sets the time that the most recently measured operating condition value was received and/or measured as an interval end time. The interval period is set to be the time between the interval start time and the interval end time, and the duration of the interval period (hereinafter referred to as the "interval duration") is obtained by subtracting the interval start time from the interval end time. Alternatively, the interval start time, the interval end time, the interval period, and/or the interval duration may be defined or set to be any other time that enables method 200 to function as described herein. In one embodiment, processor 128 calculates 208 the average value (hereinafter referred to as the "interval average value") of the operating condition during the interval period by summing each measured value of the operating condition during the interval period and dividing the sum by the number of values during the interval period. Processor 128 stores the interval average value and the interval duration in memory 136.

Processor 128 calculates 210 a second value of the temperature of the component during a second period of time, such as during or over an operational lifetime of the component. In an example embodiment, the second value is an average (or mean) value of the temperature calculated over or during the operational lifetime of the component. Alternatively, the second value may be a rolling average, a mode, a median, a range, a standard deviation, or any other value of the temperature (or other operating condition) calculated over or during the operational lifetime of the component. As used herein, the term "operational lifetime" refers to an accumulated or total amount of time that a component has been in operation within a machine or system. For example, the operational lifetime of trip mechanism 132 is the amount of time that trip mechanism 132 has been installed in circuit protection device 122 (or any other device) while electricity has been flowing through trip mechanism 132. The operational lifetime of a component may be measured in hours, or in any other unit of time. Alternatively, the operational lifetime of a component may be measured in another unit of measurement, such as a number of startups or shutdowns of a machine or device, a number of cycles or times that the component has been switched on or off, and/or any other unit of measurement that enables method 200 to function as described herein. In an example embodiment, the operational lifetime of the component includes the interval period and a period of time before the interval period, as set forth more fully herein.

In an alternative embodiment, processor 128 does not determine 206 whether the predefined event has occurred before calculating 210 the average value of the component. Rather, in such an embodiment, processor 128 automatically and/or continuously calculates 210 the average value of the component temperature during the operational lifetime of the component, for example, when each new temperature measurement is received.

In an example embodiment, to calculate 210 the average value (hereinafter referred to as the "operational lifetime average value") of the operating condition over the operational lifetime of the component, processor 128 determines whether data exists in memory 136 for the average value of the operating condition over the operational lifetime prior to the interval period of time (hereinafter referred to as the "prior operational period"). In an example embodiment, the data includes the average value (hereinafter referred to as the "prior operational average value") of the operational condition during the prior operational period, and the duration (hereinafter referred to as the "prior operational duration") of the prior operational period. If no data exists for the prior operational period, processor 128 sets the operational lifetime average value to be equal to the average value of the operational condition during the interval period. However, if the data exists for the prior operational period, processor 128 receives the prior operational average value and the prior operational duration from memory 136, and calculates a prior accumulated condition value for the operating condition by multiplying the prior operational average value and the prior operational duration.

Processor 128 calculates an interval accumulated condition value by multiplying the interval average value and the interval duration. Processor 128 also calculates the operational lifetime duration by summing the prior operational duration and the interval duration. The interval accumulated condition value and the prior accumulated condition value are summed together, and divided by the operational lifetime duration to obtain the operational lifetime average value of the operating condition. In an example embodiment, the operational lifetime average value and the operational lifetime duration are stored in memory 136. In addition, processor 128 sets, or updates, the prior operational average value to be equal to the operational lifetime average value and sets, or updates, the prior operational duration to be equal to the operational lifetime duration for use in future calculations.

In an alternative embodiment, processor 128 calculates 210 the operational lifetime average value based on an amount of time that the component has operated within each of a plurality of predefined temperature (or other operating condition) ranges. For example, processor 128 determines the amount of time that the temperature of the component is within each temperature range (e.g., 11-20 degrees C, 21-30 degrees C, 31-40 degrees C, etc.) and calculates an average value for temperatures within each temperature range (e.g., a value of 35.5 for the temperature range of 31-40 degrees C, and a value of 25.5 for the temperature range of 21-30 degrees C). Processor 128 calculates the operational lifetime average value of the operating condition using the average value of each temperature range and the amount of time that the temperature of the component is within each temperature range.

In one embodiment, processor 128 selects and applies a weight value to the temperature ranges such that the amount of time that the temperature is within each temperature range is multiplied by a weight value associated with each temperature range. The weight value represents an effect of operating the component at a higher or a lower temperature with respect to a normal, or baseline, operating temperature threshold. For example, if the normal operating temperature threshold is about 30 degrees C, operating at a temperature higher than 30 degrees C may cause additional stress on the component such that the operational lifetime of the component is reduced. Accordingly, in one embodiment, processor 128 may apply a weight value of 1.2 to the time that the temperature was within a temperature range of 41-50 degrees C and a weight value of 1.4 to the time that the temperature was within a temperature range of 51-60 degrees C. Alternatively, the weight values and/or temperature ranges may be any value and/or range that enables power distribution system 104 to function as described herein.

After processor 128 calculates 210 the operational lifetime average value of the operating condition, processor 128 receives 212 expected lifetime data for the component from a memory, such as memory 136. In an example embodiment, the expected lifetime data for the component includes a number of hours (or another unit of time) (also referred to as the "expected component lifetime") the component is expected to operate at a predefined value of the operating condition before the component fails. For example, the expected lifetime data may indicate that a trip mechanism 132 is expected to operate at a temperature of about 30 degrees Centigrade (C) for about 262,000 hours before trip mechanism 132 fails. In an example embodiment, the expected lifetime data is received from a user (i.e., from user input device 120) and/or from another system or device coupled to memory 136, and the expected lifetime data is stored in a table or another data structure in memory 136. In addition, the expected lifetime data is associated with a plurality of component operating temperatures. More specifically, each component operating temperature is correlated with an expected component lifetime for that temperature (i.e., a component is expected to operate at a temperature for a number of hours equal to the expected component lifetime value associated with that temperature). In one embodiment, the expected lifetime data is obtained or interpolated from a component reliability model, such as a Bellcore prediction model.

Processor 128 calculates 214 a status, such as an expected remaining useful life, of the component based on the operational lifetime average value and the expected lifetime data of the component. Alternatively, the status may be a remaining thickness of an electrical contact, a normal operating range or a recommended operating range of the temperature or other operating condition of the component, a notification or warning that the operating condition of the component is outside of the normal operating range and/or the recommended operating range, an identification of a maintenance issue, an identification of a change in an operating mode or condition of the component, and/or any other status indication or value of the component. In an example embodiment, processor 128 receives the expected component lifetime associated with the operational lifetime average value from memory 136. In one embodiment, the expected component lifetime is interpolated from a temperature value stored within memory 136 that is closest to the operational lifetime average value. Processor 128 subtracts the operational lifetime duration for the component from the expected component lifetime to calculate or determine the remaining useful life of the component. Processor 128 then determines 216 if the remaining useful life of the component is below a predefined threshold value. In one embodiment, the predefined threshold value is equal to about 10 percent of the expected component lifetime of the component. Alternatively, the predefined threshold value is any other number of hours that enables power distribution system 104 to function as described herein.

If the remaining useful life is not below the predefined threshold value, method 200 returns to measuring 202 the operating condition of the component as described above. However, if the remaining useful life is below the predefined threshold value, processor 128 issues 218 a warning or another notification to a user. In an example embodiment, the warning includes activating one or more LEDs or other components of display device 138 to visually indicate that the remaining useful life of the component has decreased below the threshold. Alternatively or additionally, the warning includes transmitting a data signal or message to the user, for example, through central communication unit 116, issuing a maintenance request, generating an audible alarm or other noise, changing a display of text and/or graphics on display device 138, and/or any other warning or notification. In one embodiment, processor 128 trips, or activates, trip mechanism 132 to prevent current from being delivered to load 124 before, after, or substantially during the issuance of the warning.

In addition, processor 128 optionally implements 220 one or more actions to extend or increase the remaining useful life of the component. For example, if circuit protection device 122 is configured to trip, or activate trip mechanism 132, when a measured temperature exceeds a first threshold, such as about 90 degrees C, processor 128 may configure circuit protection device 122 to trip, or activate trip mechanism 132, when the measured temperature exceeds a second, lower threshold, such as about 70 degrees C. Accordingly, processor 128 may adjust the trip threshold of trip mechanism 132 if the remaining useful life of trip mechanism 132 is less than the remaining useful life threshold value. Additionally or alternatively, if circuit protection device 122 is configured to trip, or activate, according to a first predefined trip time curve, processor 128 may be configured to select a second predefined trip time curve that causes circuit protection device 122 to trip, or activate, more quickly than the first trip time curve. Accordingly, an amount of current flowing through circuit protection device 122 and trip mechanism 132 may be reduced, thus reducing an amount of heat generated within circuit protection device 122. As the operating life of a component may be at least partially based on the operating temperature of the component, reducing the temperature within circuit protection device 122 may increase the operational life of trip mechanism 132. After implementing 220 one or more actions, method 200 may return to measuring 202 the operating condition of the component.

Technical features of the method, device, and system described herein may include one or more of: (a) measuring an operating condition of a component; (b) storing values representative of an operating condition of a component in a memory; (c) calculating a first value of an operating condition of a component during a first period of time based on stored values; (d) calculating a second value of an operating condition of a component during a second period of time using a first value; and (e) determining an amount of remaining useful life of a component using a second value.

Example embodiments of a method, device, and system for monitoring a component are described above in detail. The method, device, and system are not limited to the specific embodiments described herein but, rather, operations of the method and/or components of the system and/or device may be utilized independently and separately from other operations and/or components described herein. Further, the described operations and/or components may also be defined in, or used in combination with, other systems, methods, and/or devices, and are not limited to practice with only the system, method, and device as described herein.

Although the present invention is described in connection with an example circuit protection system, embodiments of the invention are operational with numerous other circuit protection systems, or other systems or devices. The circuit protection system described herein is not intended to suggest any limitation as to the scope of use or functionality of any aspect of the invention. In addition, the circuit protection system described herein should not be interpreted as having any dependency or requirement relating to any one or combination of components illustrated in the example operating environment.

The order of execution or performance of the operations in the embodiments of the invention illustrated and described herein is not essential, unless otherwise specified. That is, the operations may be performed in any order, unless otherwise specified, and embodiments of the invention may include additional or fewer operations than those disclosed herein. For example, it is contemplated that executing or performing a particular operation before, contemporaneously with, or after another operation is within the scope of aspects of the invention.

Although specific features of various embodiments of the invention may be shown in some drawings and not in others, this is for convenience only. In accordance with the principles of the invention, any feature of a drawing may be referenced and/or claimed in combination with any feature of any other drawing.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A system (100) comprising:
a sensor (130) configured to provide a signal related to an operating condition of a component;
a memory (136) for storing values representative of the operating condition;
and
a processor (128) coupled to said sensor and to said memory, said processor programmed to:
calculate a first value of the operating condition during a first period of time based on the stored values;
calculate a second value of the operating condition during a second period of time using the first value; and
determine a status of the component using the second value.

2. A system (100) in accordance with Claim 1, wherein:
the first value is one of an average, a rolling average, a mode, a median, a range, and a standard deviation of the operating condition during the first period of time; and/or
the second value is one of an average, a rolling average, a mode, a median, a range, and a standard deviation of the operating condition during the second period of time.

3. A system (100) in accordance with Claim 1 or Claim 2, wherein said processor (128) is programmed to calculate the second value of the operating condition of the component over an operational lifetime of the component.

4. A system (100) in accordance with Claim 3, wherein said processor (128) is programmed to determine the status of the component by:
receiving an expected lifetime of the component based on the second value;
and
subtracting a duration of the operational lifetime from the expected lifetime of the component.

5. A system (100) in accordance with Claim 4, wherein said processor (128) is programmed to determine the status of the component to be a remaining useful life of the component.

6. A system (100) in accordance with Claim 5, wherein said processor (128) is further programmed to issue a notification if the remaining useful life is less than a threshold value.

7. A system (100) in accordance with Claim 6, wherein the threshold value is based on the expected lifetime of the component.

8. A system (100) in accordance with Claim 6 or Claim 7, wherein said processor (128) is further programmed to implement an action to extend the remaining useful life of the component if the remaining useful life is less than the threshold value.

9. A system (100) in accordance with Claim 8, wherein the action includes at least one of reducing an amount of current flowing through the component, reducing a temperature of the component, and reducing a humidity of air in close proximity to the component.

10. A system in accordance with Claim 8 or Claim 9, wherein the component is a trip mechanism configured to interrupt a current provided to a load, said processor (128) is programmed to implement the action by adjusting a trip threshold for the trip mechanism.

11. A system in accordance with any preceding Claim, wherein the status is at least one of a remaining useful life of the component, a remaining thickness of an electrical contact within the component, a normal operating range of the operating condition of the component, a recommended operating range of the operating condition of the component, a notification that the operating condition of the component is outside of an operating range of the component, an identification of a maintenance issue, and an identification of a change in the operation of the component.

12. A circuit protection device for use in electrically protecting a load, said circuit protection device comprising:
a trip mechanism configured to interrupt a current provided to the load; and
a system in accordance with any preceding Claim.

13. A method for monitoring a component, said method comprising:
measuring an operating condition of the component, wherein the operating condition includes a temperature of the component;
storing values representative of the operating condition in a memory (136);
calculating, by a processor (128), a first value of the operating condition during a first period of time based on the stored values;
calculating, by a processor (128), a second value of the operating condition during a second period of time using the first value; and
determining, by a processor (128), a remaining useful life of the component using the second value.

14. A method in accordance with Claim 13, wherein calculating the second value comprises calculating the second value of the operating condition of the component over an operational lifetime of the component.

15. A method in accordance with Claim 14, wherein determining the remaining useful life of the component comprises:
receiving an expected lifetime of the component based on the second value;
and
subtracting a duration of the operational lifetime from the expected lifetime of the component.

16. A method in accordance with Claim 15, further comprising:
issuing a notification if the remaining useful life is less than a threshold value;
and/or.
implementing an action to extend the remaining useful life of the component if the remaining useful life is less than the threshold value.
